# EUROPEAN PATENT APPLICATION

(11) **EP 1 199 743 A2**
(43) Date of publication of application: **24.04.2002**
(21) Application number: 01122519.0
(22) Date of filing: 21.09.2001
(51) Int. Cl.: H01L 21/314

(54) **Method of fabricating a stack consisting of a layer of Si3N4 topped by a layer of SiO2 on a semiconductor substrate**

(30) Priority: 17.10.2000 DE 10051382; 27.12.2000 US 750961
(71) Applicant: TEXAS INSTRUMENTS DEUTSCHLAND GMBH, 85356 Freising (DE)
(72) Inventor: Foglietti, Pietro, 84032 Altdorf (DE); Staufer, Berthold, 85410 Haag (DE); Artinger, Josef, 84164 Dornwang (DE)
(74) Representative: Schwepfinger, Karl-Heinz, Dipl.-Ing.

(57) **Abstract**

A method of fabricating a stack consisting of a layer of Si₃N₄ topped by a layer of SiO₂ on a semiconductor substrate involves depositing the layer of Si₃N₄ on the semiconductor substrate in a reactor in a NH₃ and bis(tert.-butylamino)silane atmosphere at a temperature of 600 to 650°C and a pressure of 40 to 53 Pa and then depositing the layer of SiO₂ on the layer of Si₃N₄ in the same reactor in an O₂ and bis(tert.-butylamino)silane atmosphere at a temperature of 600 to 650°C and a pressure of 40 to 53 Pa.

## Description

The invention relates to a method of fabricating a stack consisting of a layer of Si₃N₄ topped by a layer of SiO₂ on a semiconductor substrate.

One structure often to be fabricated in the production of integrated semiconductor circuits is a stack consisting of a layer of Si₃N₄ topped by a layer of SiO₂ on a semiconductor substrate. This structure is required more particularly in forming emitter windows in the base zones of BiCMOS circuits suitable for high-frequency operation. The base zone of the semiconductor substrate within which the emitter window is to be formed is a zone doped with boron whose profile (peak concentration, distribution width) is strongly influenced by the steps in the method subsequent to forming the base zone. More particularly, high temperatures employed over lengthy periods have an unfavorable effect on the profile to the detriment of the high-frequency response and performance of the circuit to be fabricated.

The method currently used in fabricating the layered stack is a two-step process. In the first step the semiconductor substrate is exposed to an atmosphere of NH₃ and dichlorosilane (DCS) at a temperature of 800°C in a reactor in a chemical vapor deposition process implemented at a low pressure. In this step the desired layer of Si₃N₄ is deposited on the semiconductor substrate. Then, in the second step, the semiconductor substrate is brought into a second reactor in which the desired layer of SiO₂ is deposited on the layer of Si₃N₄, again at low pressure and by chemical vapor deposition in an atmosphere of oxygen and tetraethoxysilane (TEOS) at approx. 700°C. The duration of the two steps in the method implemented in two reactors amounts to at least 8.5 hrs during which the semiconductor substrate is always at a temperature above 650°C at which the undesirable deterioration of the boron profile occurs in the base zone.

The invention is based on the object of providing a method of the aforementioned kind in which the desired layered stack is attained in a substantially shorter time and at lower temperatures.

This object is achieved by the method in accordance with the invention comprising the steps:
a) depositing the layer of Si₃N₄ on the semiconductor substrate in a reactor in a NH₃ and bis(tert.-butylamino)silane atmosphere at a temperature of 600 to 650°C and a pressure of 40 to 53 Pa;
b) depositing the layer of SiO₂ on the layer of Si₃N₄ in the same reactor in an O₂ and bis(tert.-butylamino)silane atmosphere at a temperature of 600 to 650°C and a pressure of 40 to 53 Pa.

Application of the method in accordance with the invention in fabricating the desired stack of a layer of Si₃N₄ topped by a layer of SiO₂ on a semiconductor substrate is implemented in a single process in the same reactor, enabling the dwell time to be maintained short at working temperatures which no longer result in a substantial deterioration of the doping profile of the zones located under the layered stack in the semiconductor substrate, thus permittig fabrication of integrated BiCMOS circuits having an enhanced high-frequency response.

It is assumed for the example embodiment of the method in accordance with the invention as now to be described that a BiCMOS circuit suitable for high-frequency applications is to be produced in the semiconductor substrate and that the emitter window of a bipolar transistor is to be formed in a base zone produced by doping with boron. In forming the emitter window it is necessary to first deposit on the exposed base zone a layer of Si₃N₄ approx. 35 nm thick and to top this with a layer of SiO₂ 115 nm thick.

To fabricate the layered stack the semiconductor substrate is brought into a reactor usually termed LPCVD reactor, i.e. a reactor in which a chemical vapor deposition process can be implemented at low pressure. In this reactor a low pressure is generated in the range 40 to 53 Pa and an atmosphere is generated containing NH₃ and bis(tert.-butylamino)silane in a mixture ratio of 3:1 or 2:1, The working temperature in the reactor is maintained at approx. 600°C. In this arrangement deposition of the layer of Si₃N₄ occurs at a rate which is not less than 2 nm/min. Once the layer thickness of 35 nm is attained a brief flushing cycle of approx. 10 min occurs to remove the atmosphere from the reactor having resulted in deposition of the first layer. After this flushing cycle an atmosphere of O₂ and bis(tert.-butylamino)silane is generated in the same reactor under the same pressure and temperature conditions, resulting in deposition of a layer of SiO₂ on the layer of Si₃N₄. In this arrangement the deposition rate is not less than 6 to 7 nm/min so that the desired layer thickness of 115 nm is achieved after approx. 20 min. After a repeat flushing procedure the semiconductor substrate can be forwarded to the further steps in the process.

In actual practice total processing time for fabricating a layered stack amounts to approx. 4.5 hrs whereby 150 semiconductor substrates can be processed in a single step. Total thruput can thus be specified at approx. 33 semiconductor substrates per hr.

The method as described thus results not only in semiconductor circuits having improved performance, it also permits a substantial boost in thruput in semiconductor substrate fabrication. A further substantial advantage in making use of the method as described is that it is now no longer necessary to employ dichlorosilane as needed hitherto in producing the layer of Si₃N₄, thus eliminating ammonium chloride materializing in the reactor which needs to be removed from the reactor concerned in time-consuming regular maintenance procedures to prevent the semiconductor substrates from being contaminated by the particles of ammonium chloride.

## Claims

1. A method of fabricating a stack consisting of a layer of Si₃N₄ topped by a layer of SiO₂ on a semiconductor substrate comprising the steps:
a) depositing said layer of Si₃N₄ on said semiconductor substrate in a reactor in a NH₃ and bis(tert.-butylamino)silane atmosphere at a temperature of 600 to 650°C and a pressure of 40 to 53 Pa;
b) depositing said layer of SiO₂ on said layer of Si₃N₄ in the same reactor in an O₂ and bis(tert.-butylamino)silane atmosphere at a temperature of 600 to 650°C and a pressure of 40 to 53 Pa.

2. The method as set forth in claim 1 wherein for depositing said layer of Si₃N₄, NH₃ and bis(tert.-butylamino)silane in a ratio of 3:1 or 2:1 are employed.

3. The method as set forth in claim 1 or 2 wherein said layer of Si₃N₄ is deposited 35 nm thick at a rate of not less than 2 nm/min and said layer of SiO₂ is deposited 115 nm thick at a rate of not less than 6 to 7 nm/min.
